# EUROPÄISCHE PATENTSCHRIFT

(11) **EP 3 932 156 B1**
(45) Veröffentlichungstag und Bekanntmachung des Hinweises auf die Patenterteilung: **12.11.2025**
(21) Anmeldenummer: 20704190.6
(22) Anmeldetag: 24.01.2020
(51) Int. Cl.: H05K 13/02, B65H 18/02, B65G 1/04, B65H 75/12, B65H 75/42

(54) **FIXIEREINRICHTUNG FÜR MOBILE SPULENTRÄGER ZUM AUFNEHMEN VON GURTSPULEN**
FIXING DEVICE FOR MOBILE SPOOL SUPPORTS FOR RECEIVING BELT SPOOLS
ÉQUIPEMENT DE FIXATION POUR PORTE-BOBINE MOBILE DESTINÉ À ACCUEILLIR DES BOBINES DE SANGLES

(30) Priorität: 26.02.2019 DE 102019104809
(43) Veröffentlichungstag der Anmeldung: 05.01.2022
(73) Patentinhaber: Otto Künnecke GmbH, 37603 Holzminden (DE)
(72) Erfinder: STIMPFLE, Matthias, 86759 Fessenheim (DE); GALINSKY, Benjamin, 79650 Schopfheim (DE)
(74) Vertreter: Müller Hoffmann & Partner
(86) Internationale Anmeldenummer: PCT/EP2020/051749
(87) Internationale Veröffentlichungsnummer: WO 2020/173630

(56) Entgegenhaltungen:
- EP-A2- 2 792 618
- WO-A1-2014/142374
- WO-A2-02/099726

## Beschreibung

Die Erfindung betrifft eine Einrichtung gemäß dem Oberbegriff von Anspruch 1 zum lösbaren Fixieren eines mobilen Spulenträgers für die gestapelte Aufnahme von Gurtspulen mit elektrischen Bauelementen.

Die Erfindung bezieht sich insbesondere auf eine Einrichtung zum lösbaren Fixieren eines mobilen Spulenträgers für die gestapelten Aufnahme von Gurtspulen mit elektrischen Bauelementen, wobei der Halter mit einer schlanken Rundstange versehen ist, auf die die Gurtspulen mit ihren zentralen Naben von einem oberen freien Ende her aufsteckbar sind und wobei ein unteres Ende der Rundstange zum lösbaren Fixieren des Halter dient.

Eine derartige Einrichtung ist durch die EP 2 792 618 A2 bekannt geworden. Danach ist ein Lager mit einer Vielzahl von Aufnahmefächern für die Gurtspulen mit einer Ein- und Ausgabestation versehen. Darin ist ein wechselbarer mobiler Halter für die Gurtspulen lösbar fixiert. Der Halter weist eine senkrecht stehende Rundstange mit einem durchgehenden zylindrischen Profil auf, an dem in der Nähe des unteren Endes eine Grundplatte befestigt ist. Über der Grundplatte und einem Abstandsstück ist eine Auflageplatte für die Gurtspulen axial verschiebbar gelagert. Das von der Grundplatte nach unten herausragende Ende der Rundstange ist in eine dazu passende zylindrische Aufnahme eines Schwenkfußes spielarm eingesteckt. Dies erfolgt bei einem schräg gestellten Schwenkfuß und entsprechend schräg gestelltem Halter. Eine andere Möglichkeit besteht darin, den vorzugsweise senkrecht stehenden Halter von Hand in die Aufnahme eines festen Fußteils einzufädeln und abzusenken. Die relative große Hublänge erfordert einen entsprechend höheren Einbauraum im Spulenlager und ergibt eine große Reiblänge mit entsprechendem Verschleiß, der zu einem entsprechendes Lagerspiel führt.

Die WO 2014/142374 A1 zeigt ein weiteres Beispiel einer Einrichtung zum Speichern von Gurtspulen

Die Position des oberen Stangenendes soll möglichst genau eingehalten werden. Es ist davon auszugehen, dass die Rundstange kostengünstig aus einem unbearbeiteten Stangenmaterial mit entsprechenden Durchmessertoleranzen besteht. Bei einer Vielzahl von im Umlauf befindlichen Haltern ergeben sich entsprechende Durchmesserunterschiede, was insbesondere bei der großen Lagerlänge zu Verklemmungen, auch durch Verbiegungen, führen kann. Eine relativ dünne und gerade Stange hätte hingegen ein zu großes Lagerspiel.

Der Erfindung liegt die Aufgabe zugrunde, das Einsetzen und Entnehmen des Halters bei hoher Zentriergenauigkeit zu erleichtern

Diese Aufgabe wird erfindungsgemäß durch die Einrichtung und einen Spulenträger mit den Merkmalen der jeweiligen unabhängigen Ansprüche gelöst.

Bei der Einrichtung bzw. dem Spulenträger weist das untere Ende der Rundstange ringförmig radial abstehende Kragen zur radialen Abstützung, Ausrichtung bzw. Zentrierung der Rundstange und der Rundstange auf, sind die Kragen axial beabstandet, ist der der axiale Abstand zwischen den Kragen größer als der äußere Durchmesser eines der beiden Kragen und weist die Rundstange eine nach unten weisende Anschlagschulter zu ihrer senkrechten Abstützung aufweist.

Die fest an der Rundstange ausgebildeten Kragen weisen jeweils eine kurze Führungslänge auf, die insbesondere an ihren Zentrierflächen hochgenau bearbeitet werden kann. Der axiale Abstand zwischen den Kragen ergibt eine hinreichende Stützlänge zur spielarmen Ausrichtung der Rundstange. Die Stützlänge beträgt auch ein Mehrfaches des relativ kleinen Stangenteildurchmessers. Es versteht sich, dass die Kragen an ihren Außenseiten nicht durchgehend kreisrund ausgebildet sein müssen, aber auch dann hinsichtlich ihrer Zentrierfunktion wie vollrund wirken. Durch die Kragen ist es möglich, zwei axial beabstandete Lager zu bilden, ohne das Stangenteil zu schwächen. Die Anschlagschulter kann vorteilhaft unmittelbar an einem der Kragen kompakt angeordnet sein.

Nach einer Weiterbildung der Erfindung besteht die Rundstange aus einem oberen schlanken zylindrischen Stangenteil und das untere Ende der Rundstange aus einem im Wesentlichen rotationssymmetrischen Formteil. Das Formteil kann erheblich dicker und in sich steifer ausgebildet sein als das Stangenteil. Es ist mit diesem verbunden und die Abschnitte des Formteils jeweils unterhalb der Kragen sind dünner als der darüber liegende Kragen. Das Formteil kann eine nach oben offene axiale Bohrung aufweisen, in der das untere Ende des Stangenteils fest verankert ist. Das Stangenteil kann z.B. von einem einfachen Rohmaterial abgeschnitten werden und bedarf keiner besonderen Bearbeitung. Das Formteil enthält alle für die Halterung relevanten Funktionsmaße, die z.B. durch Drehen in einer Aufspannung genau gefertigt werden können. Das Stangenteil und das Formteil können z.B. durch Verkleben oder Klemmen fest miteinander verbunden werden.

Nach einer anderen Weiterbildung der Erfindung bildet an einem der beiden Kragen ein sich nach unten verengender Kegelstumpf die Anschlagschulter, die als Zentrierelement ausgebildet ist. Der Kegelstumpf stützt sich in einer entsprechenden hohlkegeligen Aufnahme unter dem Eigengewicht der Rundstange auch nach langer Benutzung spielfrei ab und wird dabei sowohl axial wie auch radial fixiert und zentriert. Der Kegelstumpf kann an dem oberen der beiden Kragen ausgebildet sein. Der untere Kragen kann dabei eine zylindrische Zentrierform bilden. Dadurch liegt der spielfreie obere Kragen näher am die Gurtspulen aufnehmenden Nutzbereich der Rundstange.

Nach einer weiteren Ausgestaltung der Erfindung weist das Formteil an seinem unteren Ende ein sich axial erstreckendes Steckelement zum Anheben der Rundstange auf, das Steckelement kann als nach untern ragender zylindrischer Zentrierdorn ausgebildet sein, der in eine dazu passende Bohrung einer Hubeinrichtung eingesteckt werden kann, so dass die Rundstange beim Verlassen ihrer Halterung sicher in ihrer senkrechten Stellung gehalten wird.

Bei der erfindungsgemäßen Einrichtung zum lösbaren Fixieren eines mobilen Spulenträgers für die gestapelte Aufnahme von Gurtspulen mit elektrischen Bauelementen ist der Spulenträger mit einer schlanken Rundstange versehen, auf die die Gurtspulen mit ihren zentralen Naben von einem oberen freien Ende her aufsteckbar sind, wobei ein unteres Ende der Rundstange zum lösbaren Fixieren des Spulenträgers dient und wobei ein Halter für die Rundstange mit zumindest einer Zentrierbohrung zur Aufnahme des unteren Endes des Rundstange versehen ist.

Der Halter für die im Wesentlichen senkrecht stehende Rundstange weist zwei axial beabstandete Zentrierbohrungen zur spielarmen Aufnahme der Kragen auf und zwischen den Zentrierbohrungen und einer freien Außenseite des Halters verlaufen radial angesetzte Längsschlitze, deren an die Zentrierbohrungen angrenzende engste Weite jeweils kleiner ist als die Durchmesser der Bohrungen und größer als die Dicke der Formteilabschnitte unterhalb der Kragen.

Durch diese Einrichtung ist es möglich, die Rundstange an den zwei Zentrierbohrungen sicher zu lagern. Zum Entfernen der Rundstange aus der Halterung müssen die Kragen lediglich mit kurzem Hub aus den Bohrungen axial herausgehoben werden. Dadurch gelangen dünnere Abschnitte der Rundstange in den Bereich der radialen Längsschlitze, durch die die Rundstange dann seitlich herausgeführt werden kann. Das Einsetzen der Rundstange in den Halter erfolgt in umgekehrter Reihenfolge. Der kurze Hub ergibt eine sehr geringe Reibung in den Lagern mit kaum nennenswertem Verschleiß, so dass insbesondere das obere freie Ende der wackelfrei gehaltenen Rundstange nur eine geringe Lageabweichung aufweisen wird. Dadurch können die Gurtspulen am oberen Stangenende zuverlässig automatisch gewechselt werden.

Die obere der beiden Zentrierbohrungen kann vorteilhaft mit einer sich nach oben erweiternden kegelförmigen Senkung zur Auflage des Kegelstumpfs des oberen Kragens versehen sein.

Nach einer anderen Weiterbildung der Erfindung sind die beiden Zentrierbohrungen an waagerechten sich zur Außenseite hin freiragenden plattenartigen Schenkeln des Halters ausgebildet. Dabei kann die Dicke der Schenkel annähernd der Höhe der Kragen entsprechen. Dies ergibt zwischen den Platten einen großen Freiraum, der für einen Stangenwechsler den Zugang zur angehobenen Rundstange erleichtert

Nach einer anderen Weiterbildung der Erfindung ist der Halter Teil einer Übergabestation, in der der Spulenträger an einen mobilen Halter übergeben werden kann, wobei der stationäre Halter und der mobile Halter in ihren Funktionsmaßen weitgehend übereinstimmen. Die Schenkel des mobilen Halters im Bereich der Übergabestation ragen den Schenkeln des stationären Halters entgegen und die beiden Halter sind zumindest um die Dicke der Schenkel höhenversetzt angeordnet, wobei der mobile Halter die obere Höhenlage der beiden Halter einnimmt.

Diese Anordnung ermöglicht es, dass die Halter bei einer einzigen waagerechten Bewegung des mobilen Halters derart ineinander greifen können, dass ihre Zentrierbohrungen in eine koaxial fluchtende Lage gebracht und mit einer einfachen Hub- und/oder Absenkbewegung von einem zum anderen Halter übergeben werden können.

Die Kragen des im höheren der Halter fixierten Formteils liegen über den Zentrierbohrungen des unteren Halters, so dass die schmaleren Stangenteile in der Höhe der Schenkel des tiefer liegenden Halters liegen und kollisionsfrei dessen Längsschlitze passieren können. Der stationäre Halter soll während der gesamten Übergabedauer feststehen, kann aber auch nach der Übergabe weiterbewegt werden. Der mobile Halter führt während der Übergabe die waagerechte Zu- bzw. Abführbewegung aus. Dadurch dass der mobile Halter die obere Höhenlage einnimmt kann der obere Kragen entweder auf den anwesenden mobilen Halter oder nach dessen seitlichen Herausziehen auf den oberen Schenkel des stationären Halters abgesetzt werden. Würde der stationäre Halter die obere Höhenlage einnehmen, könnte der angehobene obere Kragen immer nur auf den oberen Schenkel des stationären Halters aufgesetzt werden.

Nach einer weiteren Ausgestaltung der Erfindung weist die Übergabestation eine stationäre Hubeinrichtung zum Ankoppeln an das Steckelement des Formteils und zum Anheben der Rundstange auf. Die Hubeinrichtung kann z.B. als einfacher Pneumatikzylinder ausgebildet sein, der mit einer Hubbewegung die Rundstange auf das erforderliche Übergabeniveau anhebt und auf das Halteniveau absenkt.

Nach einer anderen Weiterbildung der Erfindung ist die Übergabestation einer Station eines Lagers zur Ein- und/oder Ausgabe der Gurtspulen zugeordnet. Eine solche Ein-/Ausgabestation dient z.B. der automatischen Entnahme der vom Spulenträger einzugebenden Gurtspulen bzw. dem Befüllen des Spulenträgers mit auszugebenden Gurtspulen.

Nach einer weiteren Ausgestaltung der Erfindung ist der mobile Halter an einem mobilen Gerät angebracht ist. Das mobile Gerät kann z.B. auf einer horizontalen stationären Linearführung verschiebbar sein, die sich in der radialen Verlängerung der Längsschlitze des stationären Halters erstreckt. Dadurch kann der Spulenträger in einer geradlinigen konstanten Verfahrbewegung von der Übergabestation in eine andere Arbeitsposition, z.B. in die Ein- und Ausgabestation des Spulenlagers verfahren werden.

Der mobile Halter kann aber auch an einem automatisch geführten Transportfahrzeug für den Spulenträger angebracht sein. Es versteht sich, dass das Transportfahrzeug mehrere der Halter für mehrere der Spulenträger aufweisen kann. Mit einem solchen Fahrzeug können die Spulenträger automatisch zu beliebigen Bestückautomaten transportiert werden, an denen sie z.B. für die Bestückung von Leiterplatten bereitgestellt werden.

Die Übergabestation kann zumindest eine Positioniermarke zum lagerichtigen Andocken des Transportfahrzeugs aufweisen.

Nach einer anderen Weiterbildung der Erfindung sind mehrere der Halter an einem waagerecht umlaufenden Transportmittel ausgebildet, das der Station zur Ein- und/oder Ausgabe der Gurtspulen zugeordnet ist. Die Mehrzahl der Halter ermöglicht es gleichzeitig mehrere der Spulenträger aufzunehmen und einen Puffer für die Ein- und Ausgabe der Spulenträger zu bilden.

Das Transportmittel weist vorteilhaft zumindest zwei der Übergabestationen auf, an denen die Halter gestoppt werden können. Bei entsprechender Taktung ist es möglich, Spulenträger dem Transportmittel zeitgleich zuzuführen und zu entnehmen. Von den Übergabestationen kann eine der Ein-/Ausgabestation des Spulenlagers zugeordnet sein, die das schlittengeführte mobile Gerät aufweist. Die andere Übergabestation kann an einer gut zugänglichen Stelle des umlaufenden Transportmittels angeordnet sein.

Nach einer anderen Weiterbildung der Erfindung weist das Transportmittel einen waagerecht indexiert drehbaren Rundtisch auf, an dem die Halter in gleichmäßiger Winkelteilung und gleichem Radius angeordnet sind.

Der Rundtisch kann mit einer oberen Drehscheibe versehen sein, die die oberen Schenkel der Halter bildet. Die entsprechenden radial orientierten Zentrierbohrungen können so unmittelbar in einer Aufspannung lagegenau in die Drehscheibe eingebracht werden

Der Rundtisch kann an einer ortsfesten plattenartigen Basis gelagert sein, auf der auch die Hubeinrichtungen der Übergabestationen wie auch z.B. die Linearführung für das schlittenartig ausgebildete mobile Gerät und ein Drehantrieb für den Rundtische lagegenau angebracht sein können. Auf diese Weise bildet die Basis mit den darauf angeordneten Teilen ein komplettes Funktionsmodul, das als Terminal zur Ein- und Ausgabe der Spulenträger dient.

Im Folgenden wird die Erfindung anhand eines in den Zeichnungen dargestellten Ausführungsbeispiels näher erläutert. Es zeigen:
**Figur 1** eine Seitenansicht eines mobilen Spulenträgers für die gestapelte Aufnahme von Gurtspulen mit elektrischen Bauelementen,
**Figur 2** eine Seitenansicht und einem teilweisen Schnitt durch einen Träger und einen daran befestigten Halter für den Spulenträger nach Figur 1 mit einer stationären Hubeinrichtung,
**Figur 3** eine Draufsicht auf den Halter nach Figur 2,
**Figur 4** einen waagerechten Schnitt entlang der Linie IV - IV in Figur 2,
**Figur 5** den Halter und die Hubeinrichtung nach Figur 2 mit dem Spulenträger nach Figur 1 sowie mit einem weiteren benachbarten mobilen entgegen gerichteten Halter,
**Figur 6** die beiden Halter mit der Hubeinrichtung nach Figur 5 beim Übergeben des Spulenträger vom stationären Halter zum mobilen Halter,
**Figur 7** die Teile nach Figur 6 unmittelbar nach der Übergabe des Spulenträgers an den mobilen Halter,
**Figur 8** die Teile nach Figur 7 während des Abtransports des Spulenträgers durch den mobilen Halter,
**Figur 9** einen modifizierten Spulenträger mit einer modifizierten Hubeinrichtung,
**Figur 10** einen weiter modifizierten Spulenträger mit einem modifizierten Halter,
**Figur 11** eine perspektivische Ansicht eines selbst steuernden Transportfahrzeugs mit zwei der Halter nach Figur 1 und einem Spulenträger,
**Figur 12** eine Seitenansicht eines Terminals zur Ein- und Ausgabe der Spulenträger in ein Spulenlager, und
**Figur 13** eine Draufsicht aus das Terminal nach Figur 1

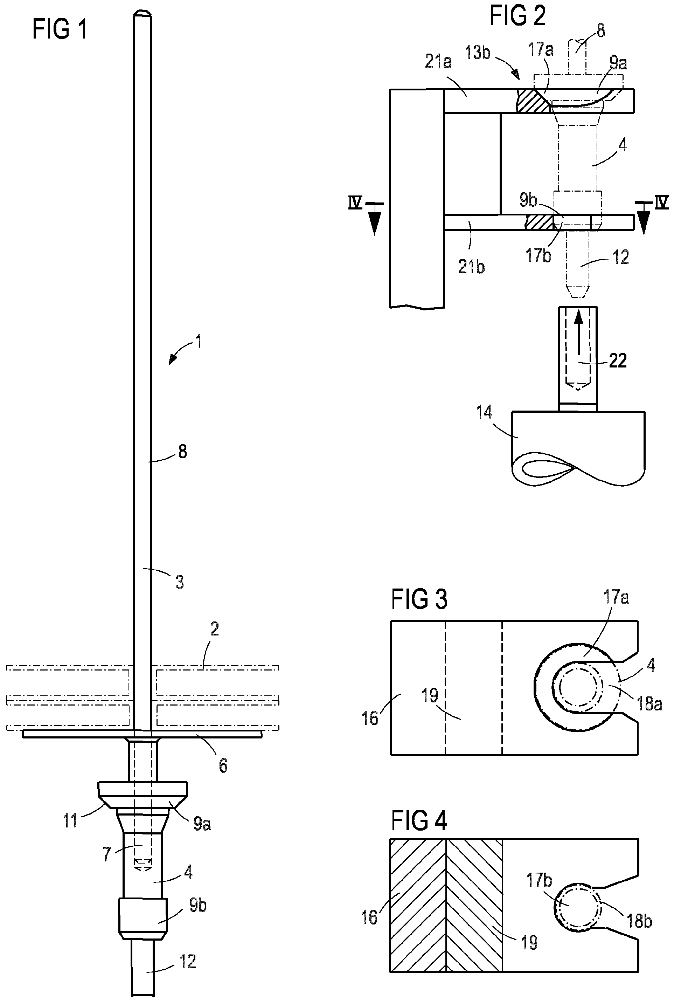

Nach Figur 1 ist ein Spulenträger 1 für in Gurtspulen 2 aufgenommene elektrische Bauelemente aus einem schlanken langen zylindrischen Stangenteil 3, einem rotationssymmetrischen Formteil 4 und einem am Stangenteil 3 verschiebbar geführten anhebbaren Auflageteller 6 zusammengesetzt. Die strichpunktiert angedeuteten Gurtspulen 2 liegen auf dem Aufnahmeteller 6 auf, der mittels eines nicht dargestellten untergreifenden externen Lifts soweit angehoben werden kann, dass die Gurtspulen 2 an das obere Ende des Stangenteils 3 gelangen, wo sie von einem nicht dargestellten externen Greifer entnommen werden können.

Das untere Ende des Stangenteils 3 in eine nach oben offene zentrale Bohrung 7 des Formteils 4 eingesetzt und mit diesem z.B. durch Kleben oder Klemmen fest verbunden. Das Stangenteil 3 und das Formteil 4 bilden zusammen eine Rundstange 8. Das einstückige längliche Formteil 4 ist mit zwei radial ringartig abstehenden Kragen 9a, 9b versehen, deren axialer Abstand größer ist als der Durchmesser eines der beiden Kragen und ein Mehrfaches des Stangenteildurchmessers beträgt. Die Abschnitte des Formteil 4 unterhalb der Kragen 9a,9b sind jeweils dünner als der darüber liegende Kragen. Am oberen Kragen 9a ist eine nach unten weisende Anschlagschulter 11 zum Abstützen der Rundstange 8 in axialer Richtung ausgebildet. Die Kragen 9a, 9b dienen als Zentrierelemente zur radialen Fixierung der Rundstange 8. Die Anschlagschulter 11 ist als sich nach unten verengender Kegelstumpf ausgebildet, der nicht nur der axialen Abstützung, sondern auch der radialen Zentrierung dient.

Der untere Kragen 9b weist einen zylindrischen Außenmantel zur radialen Fixierung der Rundstange 8 auf. Am unteren Ende des Formteils 4 ist ein koaxial nach unten ragender, als Steckelement dienender Zentrierdorn 12 zum Ankoppeln einer Hubeinrichtung ausgebildet.

Die Figuren 2 bis 4 zeigen einen stationären Halter 13 für die strichpunktiert angedeutete Rundstange 8 nach Figur 1 sowie einen Teil einer stationären Hubeinrichtung 14 für die Rundstange 8. Der Halter 13 ist an einem stangenförmigen, sich senkrecht erstreckenden Trägerteil 16 befestigt. Er weist zwei senkrecht koaxial übereinander liegende Zentrierbohrungen 17a, 17b im axialen Abstand der Kragen 9a, 9b auf. Die untere Zentrierbohrung 17b hat einen an den unteren Kragen 9b eng angepassten Durchmesser, wodurch der untere Kragen 9b radial weitgehend spielfrei fixiert wird. Die obere Zentrierbohrung 17a ist in Anpassung an die kegelförmige Anschlagschulter 11 des Formteils 4 als sich nach oben erweiternde kegelförmige Senkung ausgeformt, so dass hier die aufliegende Rundstange 4 in axialer und radialer Richtung definiert spielfrei fixiert werden kann. Die beiden hinreichend beabstandeten Zentrierbohrungen 17 a, b weisen eine Stützlänge auf, die axiale Ausrichtung der Rundstange 3 (Fig. 1) sichert.

Zwischen der dem Trägerteil 16 abgewandten freien Außenseite des Halters 13 und den Zentrierbohrungen 17a, b verlaufen radial an diese angesetzte Längsschlitze 18a, 18b, die sich parallel zur Längsachse der Zentrierbohrungen erstrecken. Die Längsschlitze 18a, b sind am Übergang zu den Zentrierbohrungen 17a, b jeweils enger als deren Durchmesser und weiter als die an die Zentrierbohrungen angrenzende Formteilabschnitte unterhalb der Kragen 9a, b. Im abgesenkten Zustand sind die Kragen 9a, b hinreichend von den geschlitzten Zentrierbohrungen umschlossen und radial fixiert. Der Durchmesser der oberen Zentrierbohrung 17a kann hier annähernd durch den mittleren Durchmesser der kegelförmigen Senkung definiert werden. Das aus den Zentrierbohrungen 17a, b herausgehobene Formteil 4 kann dann seitlich aus dem Halter 13 herausgeführt werden. Der Halterabschnitt zwischen den Zentrierbohrungen 17a, b kann eine beliebige Freimachung bilden, die das seitliche Herausführen des Formteils durch die Längsschlitze 18 a, b nicht behindert.

Der Halter 13 weist einen am Trägerteil 16 fest verankerten Verbindungsklotz 19 auf, an dem zwei übereinander angeordnete waagerechte plattenförmige Schenkel 21a, 21b befestigt sind, die die Zentrierbohrungen 17a, 17b aufweisen. Dabei ist die Dicke der Schenkel 21a, b der Höhe der Zentrierbohrung angepasst. Zwischen dem oberen Schenkeln 21a und dem unteren Schenkel 21b ergibt sich ein Freiraum, der den Zugang zum Formteil 4 für externe Greifmittel ermöglicht.

Die als pneumatischer Hubzylinder ausgebildete stationäre Hubeinrichtung 14 ist mit Abstand unterhalb des unteren Halters 13b angeordnet. Eine nach oben ragende Kolbenstange des Hubzylinders ist in der axialen Verlängerung der Zentrierbohrungen angeordnet. Sie hat ein nach oben offenes Bohrloch 22, das auf den angepassten Zentrierdorn 12 des Formteils aufgeschoben werden kann, um diesen aus den Zentrierbohrungen 17a, b ohne seitliche Kippgefahr heraus zu heben. Der Halter 13 und die Hubeinrichtung 14 bilden eine einfache Übergabestation, in der der Spulenträger an einen weiteren mobilen Halter übergeben werden kann.

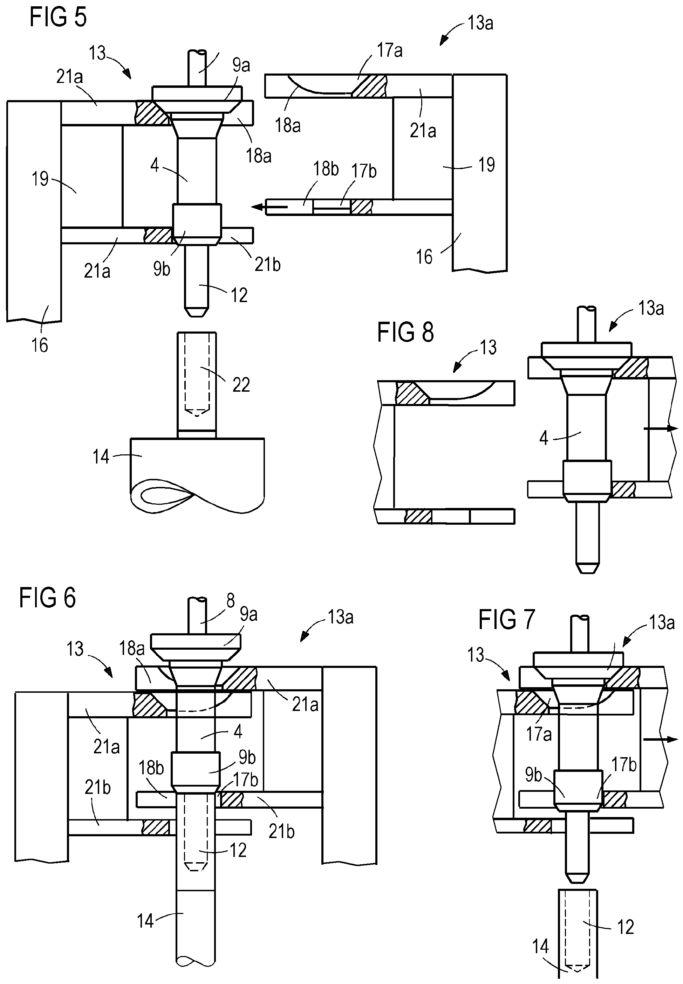

Figur 5 zeigt die Übergabestation mit dem Halter 13, der in dessen Zentrierbohrungen 17a, b gehaltenen Rundstange 8, der Hubeinrichtung 14 sowie mit einem weiteren waagerecht verschiebbaren mobilen Halter 13a von gleicher Bauform. Der mobile Halter 13b ist lediglich um etwas mehr als die Dicke des oberen Schenkels 21a höher gesetzt und über das Trägerteil 16 an einem mobilen Gerät gehalten. Unmittelbar vor der Übergabe sind hier die Halter 13, 13a mit ihren freien Schenkelenden einander zugewandt, so dass der mobile Halter 13a mit seinen Schenkeln 17a, b in den Haltebereich des stationären Halters 13 gemäß der angedeuteten Pfeilrichtung verschoben werden kann.

Figur 6 zeigt die Teile nach Figur 5, in einem Folgeschritt. Das vom stationären Halter 13 gehaltene Formteil 4 ist nun durch die Hubeinrichtung 14 aus dem Halteniveau in eine Übergabeniveau angehoben, in dem die Kragen 9a, b über den Oberseiten der Schenkel 21a, b des mobilen Halters 13a liegen. Dabei stützt sich das Formteil 4 an einer Kolbenstange der Hubeinrichtung 14 ab, wobei der in das Bohrloch 22 hineinragende Zentrierdorn 12 die senkrechte Stellung der Rundstange 8 sichert. Der mobile Halter 13a ist dann mit seinen Zentrierbohrungen 17a, b in den Haltebereich des stationären Halters 13 waagerecht verschoben worden, wobei die dünneren Abschnitte des Formteils 4 durch die mobilen Längsschlitze 18a, b passiert wurden und die Zentrierbohrungen 17a, b der beiden Halter 13, 13 a in eine koaxial übereinstimmende Lage gelangen.

Figur 7 zeigt die Teile nach Figur 6 in einem weiteren Folgeschritt, in dem die Hubeinrichtung 14 in seine Ausgangsstellung abgesenkt wurde. Dabei gelangen die beiden Kragen 9a, b in den Eingriffsbereich der Zentrierbohrungen 17a, b des mobilen Halters 13a, wobei der obere Kragen 9a einen axialen Anschlag an der Kegelsenkung der oberen Zentrierbohrung 17 a bildet. Der mobile Halter 13a kann nun mit dem darin gehaltenen Spulenträger entsprechend der angedeuteten Pfeilrichtung aus dem Überdeckungsbereich des stationären Halters 13 durch dessen Längsschlitze in die in Figur 8 dargestellte Fahrposition herausgezogen werden, in der der mobile Halter 13a auf dem Weg zu einem Einsatzort des Spulenträgers ist.

Es versteht sich, dass die bis hier beschriebenen Vorgänge auch in umgekehrter Richtung und Abfolge ausgeführt werden können.

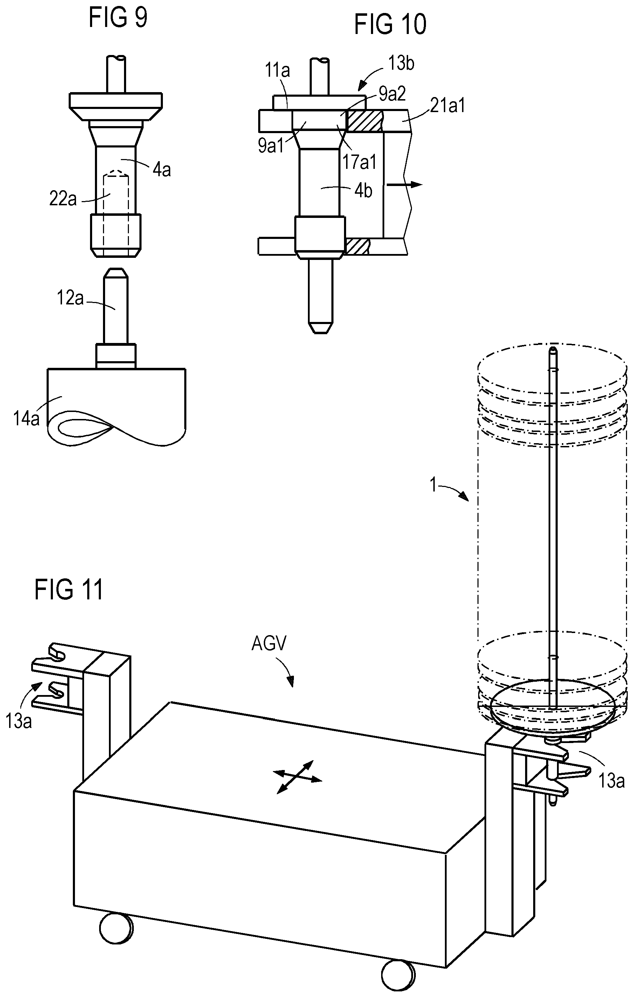

Figur 9 zeigt alternativ ein modifiziertes Formteil 4a mit einer modifizierten Hubeinrichtung 14a, wobei der Zentrierdorn 12 an der Hubeinrichtung 14a und das Zentrierloch 22 am modifizierten Formteil 4a ausgebildet sind.

Figur 10 zeigt alternativ ein weiter modifiziertes Formteil 4b und einen modifizierten Halter 13b mit einer oberen zylindrischen Zentrierbohrung 17a1 und einem oberen zylindrische Kragen 9a1, sowie mit einer am modifizierten oberen Schenkel 21a1 flach aufliegenden Anschlagschulter 11a. Eine solche Alternative hat annähernd die gleiche Wirkung wie der konische Kragen und die konische Zentrierbohrung nach den Figuren 1 und 2.

Figur 11 zeigt schematisiert ein selbststeuerndes wendiges Transportfahrzeug AGV, wie es zunehmend zur automatisierten Materialzufuhr zu Arbeitsplätzen genutzt wird. An den Stirnseiten des Transportfahrzeugs AGV sind zwei der mobilen Halter 13a zur senkrechten Aufnahme von zwei Spulenträgern 1 angebracht. Da das Transportfahrzeug keine Vorzugsrichtung hat, können die Halter 13a an verschiedenen Seiten des Transportfahrzeugs angeordnet sein.

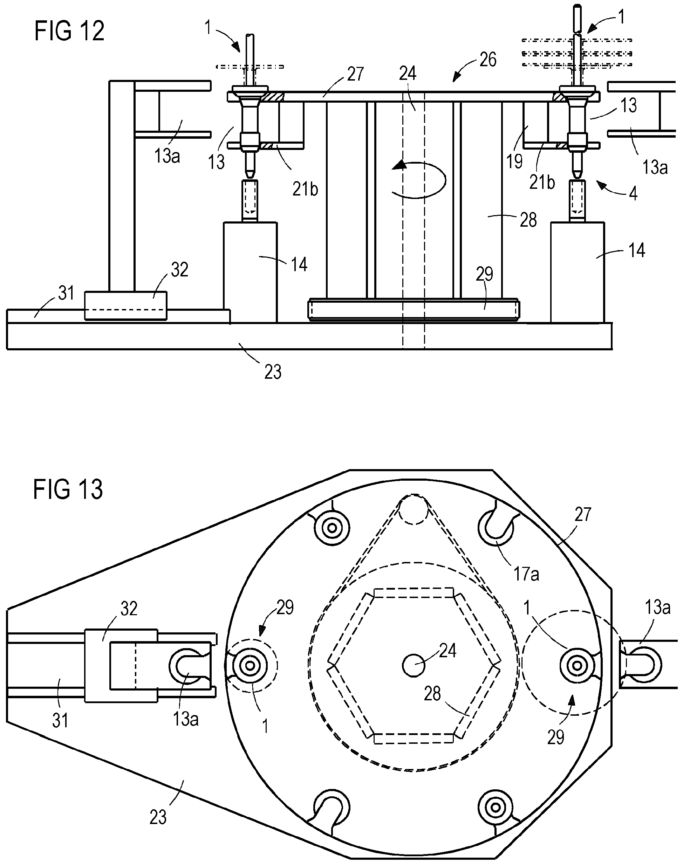

Die Figuren 12 und 13 zeigen eine Drehtischanordnung mit einer ortsfesten Basis 23, an der eine senkrechte Drehachse 24 für einen indexiert umlaufenden Rundtisch 26 fixiert ist, der mit einer oberen Drehscheibe 27 versehen ist. An deren Außenrand ist eine Mehrzahl der Halter 13 in der gleichmäßigen Winkelteilung des Indexbetriebs angeordnet ist. Die Halter 13 gleichen in ihren Funktionsmaßen den stationären Haltern 13 nach Figur 2. Die oberen Schenkel der Halter 13 sind hier Teil der Drehscheibe 26 von entsprechender Dicke. Die unteren Schenkel 21b der Halter 13 sind jeweils über den Verbindungsklotz 19 an der Drehscheibe 27 befestigt, die sich auf zu einem Polygon zusammengefügten Platten 28 abgestützt, die auf einem unteren Zahnrad 29 des Rundtischs 26 aufsitzen.

An zwei gegenüberliegenden Haltestellen der Halter 13 sind Übergabestationen 31 für die Spulenträger 1 vorgesehen. Diese Stationen sind mit den an der Basis 23 befestigten Hubantrieben 14 ausgestattet. Eine der Übergabestationen 31 befindet sich an einer frei zugänglichen Seite des Rundtischs 26, der hier z.B. für die mobilen Halter 13a des Transportfahrzeugs AGV gut zugänglich ist.

Die diametral gegenüberliegende Übergabestation 29 liegt in der Nähe einer Ein-/Ausgabestation eines Lagers für die Gurtspulen 2. Zwischen der Ein-Ausgabestation und dieser Übergabestation 31 verläuft eine horizontale stationäre Linearführung 32 für ein schlittenartiges mobiles Gerät 33, das einen weiteren der mobilen Halter13a aufweist. Die Linearführung 32 ist ebenfalls auf der entsprechend verlängerten Basis 23 befestigt. Ein über den Rundtisch 26 zugeführter Spulenträger 1 kann somit vom mobilen Gerät 33 übernommen und in die Ein-/Ausgabestation überführt werden. Obwohl hier die an der Drehscheibe angebrachten Halter 13 nicht ortsfest sind, müssen sie doch während der Übergabe vom oder zum mobilen Halter 13a eine feste Drehlage einnehmen, so dass sie als stationäre Halter 13 gelten können.

### Bezugszeichen

- 1: Spulenträger
- 2: Gurtspule
- 3: Stangenteil
- 4: Formteil
- 4a, 4b: modifiziertes Formteil
- 6: Auflageteller
- 7: Bohrung
- 8: Rundstange
- 9a, 9b: Kragen
- 9a1: zylindrischer Kragen
- 11, 11a: Anschlagschulter
- 12: Zentrierdorn
- 13, 13a: Halter
- 13b: modifizierter Halter
- 14: Hubeinrichtung
- 14a: modifizierte Hubeinrichtung
- 16: Trägerteil
- 17a, 17b: Zentrierbohrung
- 17a1: zylindrische Zentrierbohrung
- 18a, 18b: Längsschlitz
- 19: Verbindungsklotz
- 21a, 21b: Schenkel
- 21a1: modifizierter Schenkel
- 22: Bohrloch
- 23: Basis
- 24: Drehachse
- 26: Rundtisch
- 27: Drehscheibe
- 28: Platte
- 29: Zahnrad
- 31: Übergabestation
- 32: Linearführung
- 33: mobiles Gerät
- AGV: Transportfahrzeug

## Patentansprüche

1. Einrichtung zum lösbaren Fixieren eines mobilen Spulenträgers (1) für die gestapelte Aufnahme von Gurtspulen (2) mit elektrischen Bauelementen,
- wobei der Spulenträger (1) mit einer schlanken Rundstange (8) versehen ist, auf die die Gurtspulen (2) mit ihren zentralen Naben von einem oberen freien Ende her aufsteckbar sind,
- wobei ein unteres Ende der Rundstange (8) zum lösbaren Fixieren des Spulenträgers (1) dient, wobei das untere Ende der Rundstange (8) ringförmig radial abstehende Kragen (9a, 9b) zur radialen Abstützung, Ausrichtung bzw. Zentrierung der Rundstange (8) aufweist, wobei die Kragen (9a, 9b) axial beabstandet sind,
- wobei der axiale Abstand zwischen den Kragen (9a, 9b) größer ist als der äußere Durchmesser eines der beiden Kragen (9a, 9b) und wobei an einem der Kragen eine nach unten weisende Anschlagschulter (11) zur senkrechten Abstützung angeordnet ist,
**dadurch gekennzeichnet,**
- **dass** die Einrichtung einen Halter mit waagerechten, zur Außenseite hin freiragenden plattenartigen Schenkeln (21a, 21b) aufweist, wobei der Halter (13, 13a) für die Rundstange (8) mit zumindest einer Zentrierbohrung zur Aufnahme des unteren Endes der Rundstange (8) versehen ist,
- **dass** der Halter (13, 13a) für die im Wesentlichen senkrecht stehende Rundstange (8) zwei axial beabstandete Zentrierbohrungen (17a, 17b) in den waagerechten plattenartigen Schenkeln (21a, 21b) zur spielarmen Aufnahme der Kragen (9a, 9b) aufweist,
- **dass** zwischen den Zentrierbohrungen (17a, 17b) und einer freien Außenseite des Halters (13, 13a) radial angesetzte Längsschlitze (18a, 18b) verlaufen, deren an die Zentrierbohrungen (17a, 17b) angrenzende Weite jeweils kleiner ist als die Durchmesser der Zentrierbohrungen (17a, 17b) und größer als die Dicke der Formteilabschnitte unterhalb der Kragen (9a, 9b), und
- **dass** einer der Schenkel eine hohlkegelige Aufnahme zur Abstützung der Anlageschulter aufweist.

2. Einrichtung nach Anspruch 1, wobei die obere der beiden Zentrierbohrungen (17a, 17b) mit einer sich nach oben erweiternden kegelförmigen Senkung zur Auflage eines Kegelstumpfs eines oberen Kragens (9a) der beiden Kragen (9a, 9b) versehen ist.

3. Einrichtung nach Anspruch 1 oder 2, wobei die Dicke der Schenkel (21a, 21b) annähernd der Höhe der Kragen (9a, 9b) entspricht.

4. Einrichtung nach einem der vorhergehenden Ansprüche, ferner aufweisend:
- einen mobilen Halter (13), wobei der Halter (13) ein stationärer Halter (13) ist und Teil einer Übergabestation (31) ist, in der der Spulenträger (1) an den mobilen Halter (13a) übergeben werden kann, wobei
- der stationäre Halter (13) und der mobile Halter (13a) in ihren Funktionsmaßen weitgehend übereinstimmen,
- die Schenkel (21a, 21b) des mobilen Halters (13a) im Bereich der Übergabestation (31) den Schenkeln (21a, 21b) des stationären Halters (13) entgegenragen,
- der stationäre Halter (13) und der mobile Halter (13a) zumindest um die Dicke der Schenkel (21a, 21b) höhenversetzt angeordnet sind, und
- der mobile Halter (13a) derart ausgestaltet ist, das obere Höhenniveau der beiden Halter (13, 13a) einzunehmen.

5. Einrichtung nach Anspruch 4, wobei
- der mobile Halter (13a) der höhere der beiden Halter (13, 13a) ist und
- die Kragen (9a, 9b) eines im mobilen Halter (13a) fixierten Formteils (4) über den Schenkeln (21b) des unteren, stationären Halters (13) liegen.

6. Einrichtung nach Anspruch 5, wobei die Übergabestation (31) eine stationäre Hubeinrichtung zum Ankoppeln an das Steckelement des Formteils (4) und zum Anheben der Rundstange (8) aufweist.

7. Einrichtung nach Anspruch 4, 5 oder 6, wobei die Übergabestation (31) einer Station eines Lagers zur Ein- und/oder Ausgabe der Gurtspulen (2) zugeordnet ist.

8. Einrichtung nach einem der Ansprüche 4 bis 7, wobei der mobile Halter (13a) derart ausgestaltet ist, an einem mobilen Gerät (33) angebracht zu werden.

9. Einrichtung nach Anspruch 8, wobei
- das mobile Gerät als selbststeuerndes Transportfahrzeug (AGV) ausgebildet ist und
- die Übergabestation (31) zumindest eine Positioniermarke zum lagerichtigen Andocken des Transportfahrzeugs (AGV) aufweist.

10. Einrichtung nach einem der vorhergehenden Ansprüche, aufweisend mehrere Halter (13), die einem waagerecht umlaufenden Transportmittel ausgebildet sind, das einer Station zur Ein- und/oder Ausgabe der Gurtspulen (2) in ein Spulenlager zugeordnet ist.

11. Einrichtung nach Anspruch 10, wobei das Transportmittel zumindest zwei Übergabestationen (31) aufweist, an denen die mehreren Halter (13) gestoppt werden können.

12. Einrichtung nach Anspruch 11, wobei
- das Transportmittel einen waagerechten indexiert drehbaren Rundtisch (26) aufweist, an dem die mehreren Halter (13) in gleichmäßiger Winkelteilung ausgebildet sind und
- der Rundtisch (26) eine obere Drehscheibe (27) aufweist, die die oberen Schenkel der mehreren Halter (13) bildet.

13. Einrichtung nach Anspruch 12, wobei der Rundtisch an einer ortsfesten plattenartigen Basis (23) gelagert ist auf der die Hubeinrichtungen (14) der Übergabestationen (31) angebracht sind.

14. Spulenträger (1) mit einer schlanken Rundstange (8), auf die Gurtspulen (2) mit ihren zentralen Naben von einem oberen freien Ende her aufsteckbar sind,
- wobei ein unteres Ende der Rundstange (8) zum lösbaren Fixieren des Spulenträgers (1) in einer Einrichtung gemäß einem der vorhergehenden Ansprüche ausgebildet ist, wobei das untere Ende der Rundstange (8) ringförmig radial abstehende Kragen (9a, 9b) zur radialen Abstützung, Ausrichtung bzw. Zentrierung der Rundstange (8) aufweist, wobei die Kragen (9a, 9b) axial beabstandet sind,
- wobei der axiale Abstand zwischen den Kragen (9a, 9b) größer ist als der äußere Durchmesser eines der beiden Kragen (9a, 9b) und wobei an einem der Kragen eine nach unten weisende Anschlagschulter (11) zur senkrechten Abstützung angeordnet ist, **dadurch gekennzeichnet, dass**
- die Rundstange (8) aus einem oberen schlanken zylindrischen Stangenteil (3) und das untere Ende der Rundstange (8) aus einem im Wesentlichen rotationssymmetrischen Formteil (4) besteht,
- das Formteil (4) fest mit dem Stangenteil (3) verbunden ist und
- die Abschnitte des Formteils (4) jeweils unterhalb der Kragen (9a, 9b) dünner sind als der darüber liegende Kragen (9a, 9b).

15. Spulenzträger (1) nach Anspruch 14, wobei das Formteil (4) eine nach oben offene axiale Bohrung aufweist, in der das untere Ende des Stangenteils (3) fest verankert ist.

16. Spulenträger nach Anspruch 14 oder 15, wobei an einem der beiden Kragen (9a, 9b) ein sich nach unten verengender Kegelstumpf die Anschlagschulter (11) bildet und als Zentrierform dient.

17. Spulenträger nach Anspruch 16, wobei der Kegelstumpf an dem oberen der beiden Kragen (9a) ausgebildet ist und dass der untere der beiden Kragen (9b) eine zylindrische Zentrierform bildet.

18. Spulenträger nach einem der Ansprüche 14 bis 17, wobei das Formteil (4) an seinem unteren Ende ein sich axial erstreckendes Steckelement zum Anheben der Rundstange (8) aufweist.

19. Spulenträger nach Anspruch 18, wobei das Steckelement als nach unten ragender zylindrischen Zentrierdorn (12) ausgebildet ist.

## Claims

1. Device for detachably affixing a mobile coil carrier (1) for the stacked accommodation of belt coils (2) with electrical components,
- wherein the coil carrier (1) is provided with a slender round rod (8) onto which the belt coils (2) can be fitted with their central hubs from an upper free end,
- wherein a lower end of the round rod (8) is used for detachably fixing the coil carrier (1), wherein the lower end of the round rod (8) has annular radially projecting collars (9a, 9b) for radially supporting, aligning or centring the round rod (8), wherein the collars (9a, 9b) are axially spaced apart,
- wherein the axial clearance between the collars (9a, 9b) is greater than the outer diameter of one of the two collars (9a, 9b) and wherein a downwardly pointing stop shoulder (11) for vertical support is arranged on one of the collars,
**characterised in that**
- the device has a holder with horizontal plate-like limbs (21a, 21b) projecting freely towards the outside, wherein the holder (13, 13a) for the round rod (8) is provided with at least one centring bore for receiving the lower end of the round rod (8),
- that the holder (13, 13a) for the essentially vertical round rod (8) has two axially spaced centring bores (17a, 17b) in the horizontal plate-like limbs (21a, 21b) for receiving the collars (9a, 9b) with little play,
- that radially applied longitudinal slots (18a, 18b) extend between the centring bores (17a, 17b) and a free outer side on the holder (13, 13a) the width of which radial slots adjacent to the centring bores (17a, 17b) is in each case smaller than the diameters of the centring bores (17a, 17b) and greater than the thickness of the moulded part sections below the collars (9a, 9b), and
- that one of the limbs has a hollow tapered mount to support the stop shoulder.

2. Device according to claim 1, wherein the upper of the two centring bores (17a, 17b) is provided with an upwardly widening conical countersink for supporting a truncated cone of an upper collar (9a) of the two collars (9a, 9b).

3. Device according to claim 1 or 2, wherein the thickness of the legs (21a, 21b) corresponds approximately to the height of the collars (9a, 9b).

4. Device according to any one of the preceding claims, further comprising:
- a mobile holder (13), wherein the holder (13) is a stationary holder (13) and is part of a transfer station (31) in which the coil carrier (1) can be transferred to the mobile holder (13a), wherein
- the stationary holder (13) and the mobile holder (13a) largely correspond in their functional dimensions,
- the limbs (21a, 21b) on the mobile holder (13a) project towards the limbs (21a, 21b) on the stationary holder (13) in the area of the transfer station (31),
- the stationary holder (13) and the mobile holder (13a) are arranged offset in height by at least the thickness of the limbs (21a, 21b), and
- the mobile holder (13a) is designed to occupy the upper height level of the two holders (13, 13a).

5. Device according to claim 4, wherein
- the mobile holder (13a) is the higher of the two holders (13, 13a) and
- the collars (9a, 9b) of a moulded part (4) fixed in the mobile holder (13a) lie over the limbs (21b) of the lower, stationary holder (13).

6. Device according to claim 5, wherein the transfer station (31) has a stationary lifting device for coupling to the plug-in element of the moulded part (4) and for lifting the round bar (8).

7. Device according to claim 4, 5 or 6, wherein the transfer station (31) is assigned to a station of a store for inputting and/or outputting the belt coils (2).

8. The device according to any one of claims 4 to 7, wherein the mobile holder (13a) is designed to be attached to a mobile device (33).

9. Device according to claim 8, wherein
- the mobile device is designed as an automated guided vehicle (AGV) and
- the transfer station (31) has at least one positioning marker for docking the transport vehicle (AGV) in the correct position.

10. Device according to one of the preceding claims, having a plurality of holders (13) which are formed on a horizontally circulating transport means which is assigned to a station for inputting and/or outputting the belt coils (2) into a coil store.

11. Device according to claim 10, wherein the transport means comprises at least two transfer stations (31) at which the plurality of holders (13) can be stopped.

12. Device according to claim 11, wherein
- the transport means has a horizontal indexed rotatable round table (26), on which the plurality of holders (13) are formed at a uniform angular pitch, and
- the round table (26) has an upper rotating disc (27) that forms the upper limbs of the multiple holders (13).

13. Device according to claim 12, wherein the round table is mounted on a stationary plate-like base (23) on which the lifting devices (14) of the transfer stations (31) are mounted.

14. Coil carrier (1) with a slender round rod (8) onto which the belt coils (2) can be fitted with their central hubs from an upper free end,
- wherein a lower end of the round rod (8) is used for detachably fixing the coil carrier (1) in a device according to one of the preceding claims, wherein the lower end of the round rod (8) has annular radially projecting collars (9a, 9b) for radially supporting, aligning or centring the round rod (8), wherein the collars (9a, 9b) are axially spaced apart,
- wherein the axial clearance between the collars (9a, 9b) is greater than the outer diameter of one of the two collars (9a, 9b) and wherein a downwardly pointing stop shoulder (11) for vertical support is arranged on one of the collars, **characterised in that**
- the round rod (8) consists of a slender upper cylindrical rod part (3) and the lower end of the round rod (8) consists of an essentially rotationally symmetrical moulded part (4),
- the moulded part (4) is firmly connected to the rod part (3) and
- the sections of the moulded part (4) below the collars (9a, 9b) are each thinner than the collar (9a, 9b) above them.

15. Coil carrier (1) according to claim 14, wherein the moulded part (4) has an upwardly open axial bore in which the lower end of the rod part (3) is firmly anchored.

16. Coil carrier according to claim 14 or 15, wherein a downwardly narrowing truncated cone forms the stop shoulder (11) and serves as a centring form on one of the two collars (9a, 9b).

17. Coil carrier according to claim 16, wherein the truncated cone is formed on the upper of the two collars (9a) and that the lower of the two collars (9b) forms a cylindrical centring shape.

18. Coil carrier according to one of claims 14 to 17, wherein the moulded part (4) has an axially extending plug-in element at its lower end for raising the round rod (8).

19. Coil carrier according to claim 18, wherein the plug-in element is designed as a downwardly projecting cylindrical centring pin(12).

## Revendications

1. Dispositif pour fixer de manière amovible un porte-bobines mobile (1) pour la réception empilée de bobines de sangle (2) avec des composants électriques,
- dans lequel le porte-bobines (1) est pourvu d'une mince barre ronde (8), sur laquelle les bobines de sangle (2) peuvent être enfilées avec leurs moyeux centraux depuis une extrémité libre supérieure,
- dans lequel une extrémité inférieure de la barre ronde (8) sert à fixer le porte-bobines (1) de manière amovible, dans lequel l'extrémité inférieure de la barre ronde (8) présente des collerettes annulaires faisant saillie radialement (9a, 9b) pour l'appui, l'orientation ou le centrage radial de la barre ronde (8), dans lequel les collerettes (9a, 9b) sont espacées axialement,
- dans lequel la distance axiale entre les collerettes (9a, 9b) est supérieure au diamètre extérieur de l'une des deux collerettes (9a, 9b), et dans lequel un épaulement de butée (11) pointant vers le bas pour l'appui vertical est agencé sur une des collerettes,
**caractérisé en ce que**
- le dispositif présente un support comprenant des branches horizontales en forme de plaque (21a, 21b) dépassant librement vers le côté extérieur, dans lequel le support (13, 13a) pour la barre ronde (8) est pourvu d'au moins un alésage de centrage pour accueillir l'extrémité inférieure de la barre ronde (8),
- le support (13, 13a) pour la barre ronde (8) sensiblement verticale présente deux alésages de centrage (17a, 17b) espacés axialement dans les branches (21a, 21b) horizontales en forme de plaque pour l'accueil sans jeu des collerettes (9a, 9b),
- des fentes longitudinales (18a, 18b) placées radialement s'étendent entre les alésages de centrage (17a, 17b) et un côté extérieur libre du support (13, 13a), dont la largeur adjacente aux alésages de centrage (17a, 17b) est respectivement inférieure aux diamètres des alésages de centrage (17a, 17b) et est supérieure à l'épaisseur des sections de pièces moulées sous les collerettes (9a, 9b), et
- une des branches présente un logement conique creux pour l'appui de l'épaulement de butée.

2. Dispositif selon la revendication 1, dans lequel
l'alésage central supérieur des deux alésages de centrage (17a, 17b) est pourvu d'une dépression conique s'élargissant vers le haut pour supporter un cône tronqué d'une collerette supérieure (9a) des deux collerettes (9a, 9b).

3. Dispositif selon la revendication 1 ou 2, dans lequel
l'épaisseur des branches (21a, 21b) correspond approximativement à la hauteur des collerettes (9a, 9b).

4. Dispositif selon l'une des revendications précédentes, présentant en outre :
- un support mobile (13), dans lequel le support (13) est un support fixe (13) et fait partie d'une station de transfert (31), dans laquelle le support de bobine (1) peut être transféré au support mobile (13a), dans lequel
- le support fixe (13) et le support mobile (13a) coïncident dans une large mesure dans leurs dimensions fonctionnelles,
- les branches (21a, 21b) du support mobile (13a) dépassent à l'opposé des branches (21a, 21b) du support fixe (13) dans la zone de la station de transfert (31),
- le support fixe (13) et le support mobile (13a) sont agencés avec un décalage en hauteur d'au moins l'épaisseur des branches (21a, 21b), et
- le support mobile (13a) est configuré de manière à adopter le niveau de hauteur supérieur des deux supports (13, 13a).

5. Dispositif selon la revendication 4, dans lequel
- le support mobile (13a) est le plus haut des deux supports (13, 13a), et
- les collerettes (9a, 9b) d'une pièce moulée (4) fixée dans le support mobile (13a) se situent au-dessus des branches (21b) du support fixe inférieur (13).

6. Dispositif selon la revendication 5, dans lequel
la station de transfert (31) présente un dispositif de levage fixe permettant de se coupler à l'élément enfichable de la pièce moulée (4) et de soulever la barre ronde (8).

7. Dispositif selon la revendication 4, 5 ou 6, dans lequel
la station de transfert (31) est associée à une station d'un entrepôt pour l'entrée et/ou la sortie des bobines de sangle (2).

8. Dispositif selon l'une des revendications 4 à 7, dans lequel
le support mobile (13a) est configuré de manière à être installé sur un appareil mobile (33).

9. Dispositif selon la revendication 8, dans lequel
- l'appareil mobile est réalisé en tant que véhicule de transport autopiloté (AGV), et
- la station de transfert (31) présente au moins un repère de positionnement pour l'accostage correct du véhicule de transport (AGV).

10. Dispositif selon l'une des revendications précédentes, présentant
plusieurs supports (13) qui sont réalisés sur un moyen de transport circulant horizontalement, qui est associé à une station d'entrée et/ou de sortie des bobines de sangle (2) dans un entrepôt de bobines.

11. Dispositif selon la revendication 10, dans lequel
le moyen de transport présente au moins deux stations de transfert (31) sur lesquelles les plusieurs supports (13) peuvent être arrêtés.

12. Dispositif selon la revendication 11, dans lequel
- le moyen de transport présente une table ronde (26) horizontale à rotation indexée sur laquelle les plusieurs supports (13) sont réalisés selon une division angulaire régulière
et
- la table ronde (26) présente une plaque tournante supérieure (27) qui forme les branches supérieures des plusieurs supports (13).

13. Dispositif selon la revendication 12, dans lequel
la table ronde est montée sur une base (23) fixe en forme de plaque, sur laquelle sont installés les dispositifs de levage (14) des stations de transfert (31).

14. Porte-bobines (1) comprenant une mince barre ronde (8) sur laquelle des bobines de sangle (2) avec leurs moyeux centraux peuvent être enfilées depuis une extrémité libre supérieure,
- dans lequel une extrémité inférieure de la barre ronde (8) est réalisée pour fixer le porte-bobines (1) de manière amovible dans un dispositif selon l'une des revendications précédentes, dans lequel l'extrémité inférieure de la barre ronde (8) présente des collerettes annulaires faisant saillie radialement (9a, 9b) pour l'appui, l'orientation ou le centrage radial de la barre ronde (8), dans lequel les collerettes (9a, 9b) sont espacées axialement,
- dans lequel la distance axiale entre les collerettes (9a, 9b) est supérieure au diamètre extérieur d'une des deux collerettes (9a, 9b), et dans lequel un épaulement de butée (11) pointant vers le bas pour l'appui vertical est agencé sur une des collerettes, **caractérisé en ce que**
- la barre ronde (8) est constituée d'une partie supérieure de mince barre cylindrique (3) et l'extrémité inférieure de la barre ronde (8) est constituée d'une pièce moulée (4) sensiblement à symétrie de rotation,
- la pièce moulée (4) est reliée de manière solidaire à la pièce de barre (3), et
- les sections de la pièce moulée (4) sont respectivement plus minces sous les collerettes (9a, 9b) que la collerette (9a, 9b) se trouvant au-dessus.

15. Porte-bobines (1) selon la revendication 14, dans lequel
la pièce moulée (4) présente un alésage axial ouvert vers le haut dans lequel l'extrémité inférieure de la pièce de barre (3) est ancrée de manière solidaire.

16. Porte-bobines selon la revendication 14 ou 15, dans lequel
sur l'une des deux collerettes (9a, 9b), un cône tronqué se rétrécissant vers le bas forme l'épaulement de butée (11) et sert de forme de centrage.

17. Porte-bobines selon la revendication 16, dans lequel
le cône tronqué est réalisé sur la collerette supérieure des deux collerettes (9a), et la collerette inférieure des deux collerettes (9b) forme une forme de centrage cylindrique.

18. Porte-bobine selon l'une des revendications 14 à 17, dans lequel
la pièce moulée (4) présente à son extrémité inférieure un élément enfichable s'étendant axialement pour soulever la barre ronde (8).

19. Porte-bobine selon la revendication 18, dans lequel
l'élément enfichable est réalisé en tant que mandrin de centrage cylindrique (12) dépassant vers le bas.
